Europäisches Patentamt

European Patent Office

Office européen des brevets

(11) Publication number: **0 028 934**
A1

## (12) EUROPEAN PATENT APPLICATION

(21) Application number: **80304016.1**

(22) Date of filing: **11.11.80**

(51) Int. Cl.³: **H 01 L 21/268**

(30) Priority: **12.11.79 JP 146347/79**

(43) Date of publication of application:
**20.05.81 Bulletin 81/20**

(84) Designated Contracting States:
**AT BE CH DE FR GB IT LI LU NL SE**

(71) Applicant: **FUJITSU LIMITED**
**1015, Kamikodanaka Nakahara-ku**
**Kawasaki-shi Kanagawa 211(JP)**

(72) Inventor: **Mori, Haruhisa**
**2612-27-2-302, Tokaichiba-machi Midori-ku**
**Yokohama-shi Kanagawa 227(JP)**

(74) Representative: **Bedggood, Guy Stuart et al,**
**Haseltine Lake & Co. Hazlitt House 28 Southampton**
**Buildings Chancery Lane**
**London WC2A 1AT(GB)**

(54) A method of manufacturing a semiconductor device.

(57) A window is opened in an insulating film 12 on the surface of a semiconductor substrate 11 to expose a surface region (A') of the substrate. The exposed surface region (A') at least is covered with a light transmitting film 14 of a thickness ta = $m\lambda/4n$, where $\lambda$ is the wavelength of a laser beam to be employed for irradiating for selective heating and annealing in a region 13 of substrate 11 corresponding to the exposed surface region (A'), $n$ is the index of refraction of film 14 and $m$ is an odd integer (including unity).

Such a film thickness ensures effective heating of region 13 without damage to other parts of the substrate 11.

FIG.3

-1- HL 71450

# A METHOD OF MANUFACTURING A SEMICONDUCTOR DEVICE.

This invention relates to a method of manufacturing a semiconductor device.

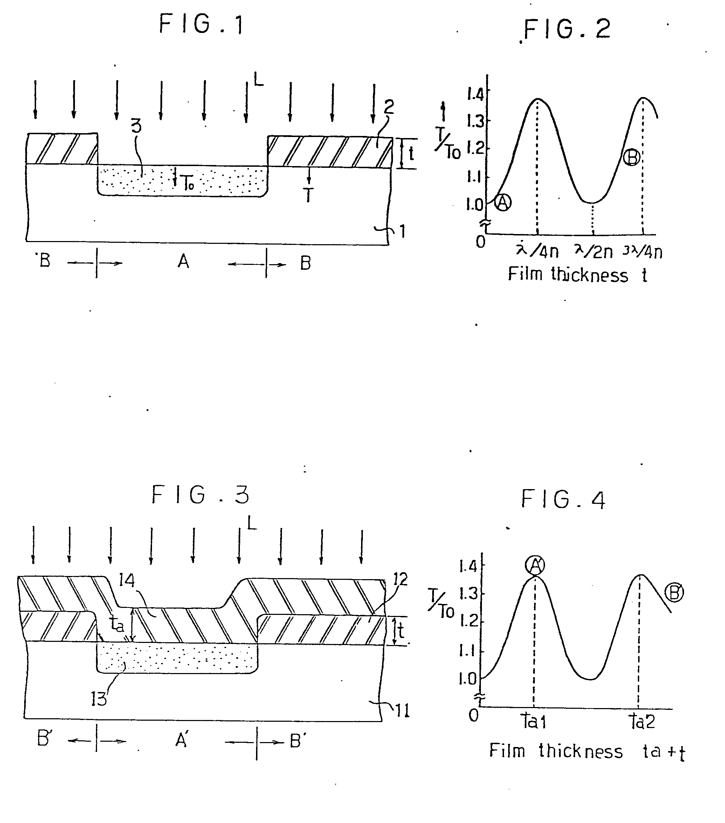

Where a semiconductor substrate, a silicon substrate for example, is annealed by irradiation by a laser beam, the rate or amount of penetration of an incident laser beam at a part of the substrate which is exposed is different from that at a part of the substrate which is covered by an insulating film such as a silicon dioxide ($SiO_2$) film. Where, as shown in Figure 1 of the accompanying drawings, which is a cross-sectional diagram, a laser beam L simultaneously irradiates an exposed area A of a silicon semiconductor substrate 1 and an area B of the substrate 1 which is covered by a film 2 of $SiO_2$, it might be assumed that the amount of incident laser beam L which penetrates into area A is larger than that which penetrates into area B, because area B is covered by the $SiO_2$ film 2. What happens in fact is quite contrary to such an assumption, and in some instances, the part of the substrate 1 in area B can be physically damaged.

According to the present invention there is provided a method of manufacturing a semiconductor device in which a surface region of a semiconductor substrate is exposed to irradiation with a laser beam of wavelength $\lambda$ for heating, and characterised by:

forming a light transmitting film, having an

index of refraction $\underline{n}$, at least on the said surface region of the semiconductor substrate, the light transmitting film being of a thickness of a value equal to, or substantially equal to, $m\lambda/4n$, where m is an odd integer (including unity), and

irradiating the said surface region of the semiconductor substrate, with the laser beam, through the light transmitting film.

A covering film, for example of $SiO_2$, may be formed to cover parts of the substrate surface other than the said surface region.

A method embodying this invention can prevent damage to those parts other than a part to be annealed in selective heat treatment or annealing by irradiation with a laser beam of a semiconductor substrate, for example a silicon substrate.

Upon investigation of the phenomenon described with reference to Figure 1, it was determined that $SiO_2$ film 2 functions as a cover which prevents reflection of laser beam L.

It was confirmed that the amount of incident laser beam L that penetrates into the substrate 1 in area A is always less than that in area B in Figure 1.

It was further found that the effectiveness of film 2 in preventing reflection of laser beam L depends on the thickness of $SiO_2$ film 2 and on the wavelength of laser beam L.

The relationship between laser beam power which penetrates into substrate 1 and thickness of $SiO_2$ film 2 is illustrated in the graph of Figure 2 of the accompanying drawings. In the graph of Figure 2 the abscissa represents film thickness $\underline{t}$ of $SiO_2$ film 2 expressed relative to the wavelength of laser beam L, and the ordinate represents the rate of penetration of incident laser beam L into the substrate 1. The rate of penetration is given as the ratio of power (or quantity) T of incident laser beam L that penetrates into the substrate 1 where it is covered by $SiO_2$ film 2, to the power

(or quantity) $T_0$ which penetrates where the substrate 1 is not covered by $SiO_2$ film 2; the ordinate thus represents the ratio $T/T_0$. It will be seen that the graph of Figure 2 shows a sine wave.

Where there is no film of $SiO_2$, that is, where $t = 0$, $T/T_0 = 1$. As will be apparent from Figure 2, where $SiO_2$ film 2 is formed on the substrate 1, the ratio of penetration, $T/T_0$ takes maximum values of approximately 1.3 $\sim$ 1.4 times the value when $t = 0$. This peak value appears where film thickness $t$ is

$$t = \lambda/4n$$

or an odd number of times that thickness, where

$\lambda$      is the wavelength of laser beam L, and

$n$      is the index of refraction of film 2.

For example, with a YAG (yttrium-aluminium-garnet) laser of $\lambda = 10600$ Å,

$$t = \frac{\lambda}{4n} = \frac{10600 \text{ Å}}{4 \times 1.46} = 1800 \text{ Å}$$

since the index of refraction $n$ of $SiO_2$ is

$$n = 1.46.$$

That is to say, the first peak or maximum value of $T/T_0$ appears where $t \simeq 1800$ Å, the second peak or maximum value appearing at

$$t = 3\lambda/4n = 5400 \text{ Å}.$$

Where $t > 0$, $T/T_0 = 1$ if film thickness $t$ is equal to $\lambda/2n$ or an integral number of times that thickness. Whenever film thickness does not satisfy such criteria,

$$T/T_0 > 1$$

so that the density of energy of incident laser beam entering into area B which is covered by $SiO_2$ film 1 is larger than the energy density in area A as shown by Ⓐ and Ⓑ in Figure 2. Previously this has caused technical disadvantages as described below.

Where the film 2 of $SiO_2$ shown in Figure 2 is used as a mask when forming a region 3 by ion implantation and the region 3 corresponds to area A which is desired to be annealed, irradiation of part of laser beam L onto area B cannot be avoided when the beam is irradiated onto region 3 in order to anneal that region 3 which is in an amorphous state. In such a case, length of time of laser irradiation and other conditions are established so as to best suit the annealing purpose. If thickness $t$ of SiO$_2$ film 2 is not $\lambda/2n$ times an integral number (including unity) or is not near such a value, excessive laser beam irradiation of area B will have taken place by the time annealing of area A has been completed. This is the cause of damage to the substrate 1 in area B which was mentioned above.

Embodiments of the present invention provide a solution to this technical problem by positively utilizing the reflection prevention function which an insulating film on a semiconductor substrate exhibits.

Briefly, in an embodiment of the invention, a window is opened through an insulating layer formed on the surface of a semiconductor substrate, and when a laser beam of wavelength $\lambda$ is to be irradiated on that part of the substrate thus exposed in the window, a light transmitting material having an index of refraction $n$ is formed to cover the entire surface of the semiconductor substrate (that is, the entire relevant part of the substrate surface, including the surface of the insulating layer, which will be irradiated by the laser beam) in such a manner that the thickness of the light transmitting material on the part where the substrate is exposed in the window is equal to, or substantially equal to, the value $\lambda/4n$ or an odd number of times that value.

In one embodiment, the light transmitting material used to cover the semiconductor substrate is a negative photoresist having an index of refraction $n = 1.48$.

In other embodiments, the light transmitting material covering the semiconductor substrate may be silicon dioxide, phospho-silicate glass, or a glass film formed by coating hydroxide of silicon or a high molecular weight polymer thereof, then heating the same at about 150°C.

Reference is made, by way of example, to the accompanying drawings, in which:-

Figure 1 is a cross-sectional view illustrating the method of laser annealing according to prior art technology,

Figure 2 is a graph illustrating the light reflection preventing characteristics of silicon dioxide film,

Figure 3 is a cross-sectional view illustrating a method embodying the present invention,

Figure 4 is a graph, similar to that of Figure 2, relating to a light transmitting material as employed in an embodiment of this invention, and

Figure 5 is a graph illustrating the relationship between the laser energy density and spreading resistance in relation to the method of Figure 1 and the method of Figure 3.

Figure 3 illustrates in cross-section a mode of carrying out one embodiment of the present invention. In a method embodying the present invention, a layer of light transmitting material 14 having a thickness of a value equal to, or substantially equal to, $ta = \lambda/4n$ or an odd number of times such a value is applied over area A', of substrate 11, which is to be annealed, then laser beam L is irradiated onto the area A'. In the above expression, $\lambda$ is the wavelength of laser L and $\underline{n}$ is the index of refraction of the light transmitting material 14. In the same manner as was explained with reference to the graph of Figure 2, where the light transmitting material 14 having a thickness ta of a value equal to, or substantially equal to, $ta = \lambda/4n$ or an odd number of times such a value is applied on the surface of a region 13 formed by ion implantation, then the ratio $T/T_0$,

that is the penetration rate of the incident laser beam into the region 13 takes a maximum value as shown in the graph of Figure 4. It should be noted here that, since the relationship between thickness ta and ratio $T/T_0$ of Figure 4 is expressed by a sine wave, slight changes in value of ta near a peak or maximum have very little effect on the ratio $T/T_0$.

In Figure 4, ta1 and ta2 correspond to $\lambda/4n$ and $3\lambda/4n$ respectively. The light transmission material is applied to cover the entire surface of semiconductor substrate 11, so that the material 14 also covers an insulating film 12 of silicon dioxide ($SiO_2$) formed in area B'. Thus, the thickness of the layers on the substrate 11 in area B', namely the total thickness of $SiO_2$ film 12 and the light transmitting material 14 is larger than the value of ta = $\lambda/4n$, which means, as will be apparent from Figure 4, that the value of $T/T_0$ in relation to area B' is generally less than a peak or maximum value of $T/T_0$. In other words, the power of incident laser beam which penetrates into the semiconductor substrate 11 in area B' has a rate of penetration which depends on the thickness of the light transmitting material 14 and that of $SiO_2$ film 12. However, the thickness of the light transmitting material 14 is established such that the amount or power of incident laser beam L penetrating into the substrate 11 takes a maximum value in area A' independently of thickness of film 12 so that the value of $T/T_0$ in area B' where the thickness of $SiO_2$ film 12 must be added to the thickness of the light transmitting material 14 is generally far less than that in area A' which is indicated by Ⓐ' or Ⓑ' in Figure 4.

Even if $T/T_0$ in area B' reaches a peak value, it is still only equal to the peak value in area A', which means that irradiation by laser beam L as suitable for annealing of the region 13 for a predetermined length of time would not damage the substrate 11 in area B'.

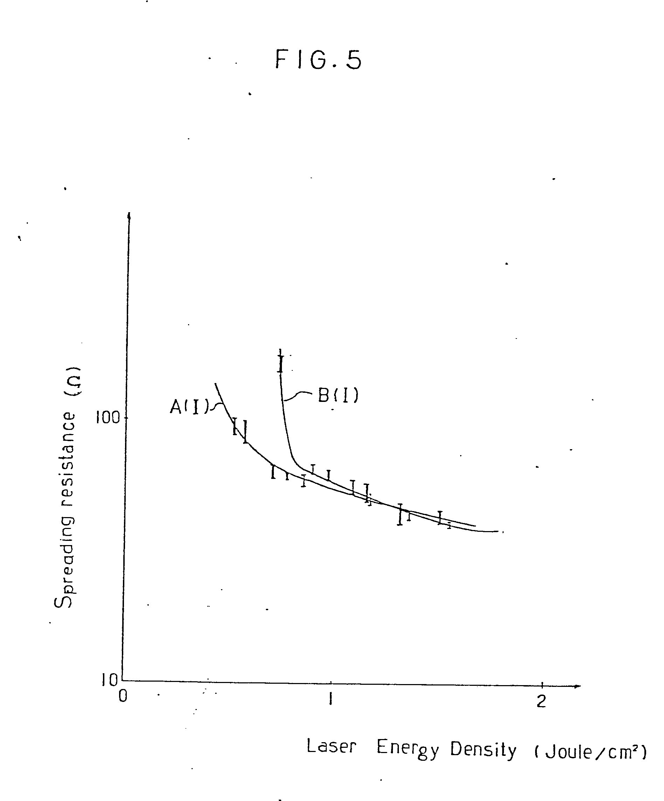

Figure 5 is a graph which illustrates the relationship between the laser energy density and the spreading resistance of the region 13.

In relation to the graph of Figure 5, a semiconductor substrate 11 was a p-type silicon substrate. The silicon substrate 11 had a resistivity of 3 $\Omega$-cm. A silicon dioxide film 12 was grown on the silicon substrate 11, by thermal oxidation, to a thickness of 8000 $\overset{o}{A}$. The silicon dioxide film 12 was selectively etched by a photolithography technique, to open a window. Arsenic (As) ions were implanted into the silicon substrate 11 with an energy of 50 Kev at a dose of $5 \times 10^{15}$ atoms/cm$^2$. Ion implanted region 13 was thus firmed in the silicon substrate 11.

The negative photoresist OMR-83, a product of Tokyo Oka Co., Ltd., was coated on the silicon substrate 11, and baked. Thus a negative photoresist layer 14 was formed, on the silicon substrate 11, with a thickness of 1090 $\overset{o}{A}$ and an index of refraction $\underline{n}$ = 1.48.

A ruby laser ( $\lambda$ = 6943 $\overset{o}{A}$) was used to provide a laser beam L for irradiating the silicon substrate.

Curve A in Figure 5 followed by a bold I in brackets relates to a case in which region 13 was covered by a negative photoresist film 14 as described above. However, curve B in Figure 5 followed by I in brackets relates to a case in which region 13 was uncovered (i.e. no film 14).

The fact that curve A(I) is offset to the left relation to curve B(I) shows that the region 13, when covered with the photoresist receives so much more energy than when it is exposed. This indicates the effect of preventing reflection of light. On the other hand, the energy density which would cause damage to SiO$_2$ film 12 is almost the same level in the two cases.

As alternatives to a photoresist film, a silicon dioxide film (SiO$_2$) thermally grown at 900$^o$C or more, an SiO$_2$ film formed by chemical vapour deposition (CVD)

at about 800$^{o}$C, a phospho-silicate glass (PSG) film formed by CVD, or a glass film formed by coating hydroxide of silicon or a high molecular weight polymer thereof, then heating the same at about 150$^{o}$C, may be employed as a light transmitting material 14.

However, since it is undesirable to interpose heat treatment between the steps of ion implantation and laser annealing which has the effect of curing crystals of the region 13, the use of a process for applying or coating the light transmitting material 14 which involves heat treatment at 500$^{o}$C or more should be avoided.

In other words, a part such as the region 13 that has been damaged (e.g. by ion bombardment) and turned amorphous is provided with a higher rate of absorption of a laser beam L than an ordinary part or a monocrystal part, and the damaged or amorphous part effectively absorbs incident laser beam L which enters thereinto from the surface. Thus, if the region 13 is in an amorphous state, laser beam L is convergently absorbed by that part to realize heating thereof. As crystallinity of region 13 is recovered, the rate of absorption of laser beam L falls, and laser energy penetrates deep into the substrate, the energy per unit volume decreases, and annealing is not effect significantly. If laser energy is convergently absorbed in the region 13, good electric characteristics, such as junction leakage current, may be obtained However, if laser energy is widely dispersed within the substrate with only a part thereof being absorbed in the region 13, it can exert adverse effects on electric characteristics. Because of these reasons, it is undesirable that the crystallinity of the region 13 be recovered before irradiation with laser beam L takes place. Therefore, a thermally grown silicon dioxide (SiO$_2$) film, a CVD SiO$_2$ film, etc. should be formed before the ion implantation process so that implantation of ions is carried out through the film already formed.

Since any of the light transmitting materials mentioned above has insulating characteristics, it can be used as an insulating layer or a mask in subsequent processes.

As has been described so far, laser annealing can be selectively and accurately performed at desired places according to a method embodying this invention without causing damage to the semiconductor substrate at places other than a desired place by such laser annealing.

In a method of manufacturing a semiconductor device comprising the steps of opening a window through an insulating layer formed on the surface of a semiconductor substrate, irradiating a laser beam of wavelength $\lambda$ onto a part of the substrate to selectively heat the irradiated part of the substrate for annealing, a method embodying this invention is characterised by the steps of coating on the entire surface of the substrate a light transmitting film having an index of refraction $\underline{n}$ in such a manner that the thickness of the film over the exposed part is equal, or substantially equal, to the value $\lambda/4n$ or $\lambda/4n$ times an odd number. A photoresist, a thermally grown silicon dioxide film, a silicon dioxide film formed by chemical vapour deposition, a CVD phosphosilicate glass film, or a glass film formed by coating hydroxide of silicon or a high molecular weight polymer thereof may be employed as the light transmitting film.

Thus, in an embodiment of this invention, an exposed substrate surface region is covered with a light transmitting film of a thickness of m $\lambda/4n$ where $\lambda$ is a laser beam wavelength, $\underline{n}$ is the index of refraction of the light transmitting film, and $\underline{m}$ is an odd integer. Substrate surface parts surrounding the exposed region, whether themselves exposed or covered over, are penetrated by the laser beam less effectively (or, at most, only as effectively) than is the

exposed region.

CLAIMS

1.    A method of manufacturing a semiconductor device
in which a surface region of a semiconductor substrate
is exposed to irradiation with a laser beam of
wavelength $\lambda$ for heating, and characterised
by:

    forming a light transmitting film, having an index
of refraction $\underline{n}$, at least on the said surface region of
the semiconductor substrate, the light transmitting
film being of a thickness of a value equal to,
or substantially equal to, m $\lambda$/4n, where $\underline{m}$ is an odd
integer (including unity), and

    irradiating the said surface region of the
semiconductor substrate, with the laser beam,
through the light transmitting film.

2.    A method as claimed in claim 1, including the
step of forming a covering film on part of the
substrate surface other than the said surface  region.

3.    A method as claimed in claim 1 or 2, wherein
the light transmitting film is a photoresist or a silicon
dioxide film, or a phospho-silicate glass film, or a
glass film formed by coating hydroxide of silicon or
a high molecular weight polymer thereof.

4.    A method as claimed in claim 3, wherein the
light transmitting film is formed before an ion
implantation step, for implating ions into the
substrate, is effected, the implantation of ions being
carried out through the film.

5.    A method as claimed in any preceding clim,
comprising opening a window through an insulating
layer previously formed on the surface of the semiconductor substrate, to expose the said surface region,
forming the light transmitting film so as to cover
extensively the said surface region of the semiconductor
substrate and the insulating layer, and irradiating
with the laser beam to heat selectively the said
surface region.

FIG.1

FIG.2

FIG.3

FIG.4

FIG.5

Laser Energy Density ( Joule/cm²)

European Patent Office

**EUROPEAN SEARCH REPORT**

Application number

EP 80 30 4016

| DOCUMENTS CONSIDERED TO BE RELEVANT | | | CLASSIFICATION OF THE APPLICATION (Int. Cl.³) |
|---|---|---|---|
| Category | Citation of document with indication, where appropriate, of relevant passages | Relevant to claim | |
| | JOURNAL OF APPLIED PHYSICS, vol. 50, no. 5, May 1979, NEW YORK (US) H. TAMURA et al.: "Laser-annealing behavior of a phosphorus-implanted silicon substrate covered with a $SiO_2$ film", pages 3783-3784 <br><br> * pages 3783-3784 * <br><br>--- | 1,3 | H 01 L 21/268 |
| | APPLIED PHYSICS LETTERS, vol. 34, no. 3, February 1, 1979, NEW YORK (US) Z.L. LIAU et al.: "Laser annealing for solid-phase thin-film reactions", pages 221-223 <br><br> * page 221, abstract; page 223, column 1, paragraph 2 to column 2, paragraph 2; figure 3 * <br><br>--- | 1,3 | **TECHNICAL FIELDS SEARCHED (Int. Cl.³)** <br><br> H 01 L 21/268 |
| | ELECTRONICS LETTERS, vol. 15, no. 14, July 5, 1979, HITCHIN-HERTS (GB) S.S. KULAR et al.: "Laser annealing of capped and uncapped GaAs", pages 413-414 <br><br> * pages 413-414 * <br><br>--- | 1 | |
| | IBM TECHNICAL DISCLOSURE BULLETIN, vol. 21, no. 10, March 1979, NEW YORK (US) R.T. HODGSON et al.: "Ohmic contacts made by lasers", page 4286 <br><br> * figure 2 * <br><br>--- | 1 | **CATEGORY OF CITED DOCUMENTS** <br><br> X: particularly relevant <br> A: technological background <br> O: non-written disclosure <br> P: intermediate document <br> T: theory or principle underlying the invention <br> E: conflicting application <br> D: document cited in the application <br> L: citation for other reasons |
| | IBM TECHNICAL DISCLOSURE BULLETIN, vol. 22, no. 2, July 1979, NEW YORK (US) <br><br>./.. | 1 | |

|  | The present search report has been drawn up for all claims | | &: member of the same patent family, corresponding document |
|---|---|---|---|
| Place of search <br> The Hague | Date of completion of the search <br> 10.02.1981 | Examiner <br> CHOMENTOWSKI | |

EPO Form 1503.1  06.78

| DOCUMENTS CONSIDERED TO BE RELEVANT | | | CLASSIFICATION OF THE APPLICATION (Int. Cl. 3) |
|---|---|---|---|
| Category | Citation of document with indication, where appropriate, of relevant passages | Relevant to claim | |
| | B.C. HENRY et al.: "Semiconductor structure with integrated infrared energy absorption layer", page 681. <br><br> * page 681 * <br> --- | | |
| | IBM TECHNICAL DISCLOSURE BULLETIN, vol. 13, no. 4, September 1970, NEW YORK (US) <br> M.L. JOSHI et al.: "Masking Technique for Laser Induced Diffusion", page 928 <br><br> * page 928 * <br> --- | 1-3,5 | |
| | PATENT ABSTRACTS OF JAPAN, vol. 1, no. 136, November 10, 1977, page 6425E77, TOKYO (JP) <br> & JP - A - 52 72162 (TOKYO SHIBAURA DENKI K.K.) June 16, 1977 <br><br> * abstract * <br> --- | 4 | TECHNICAL FIELDS SEARCHED (Int. Cl. 3) |
| | EP - A - 0 002 670 (IBM) <br><br> * abstract; page 7, line 1 to page 10, line 24; claims 2-5; figures 1-5 * <br> --- | 3 | |
| E,P | DE - A - 2 837 653 (SIEMENS A.G.) <br><br> * page 3, line 1 to page 9, line 24; figure * <br><br> --------- | 1,2 | |

EPO Form 1503.2 06.78